# DEMANDE DE BREVET EUROPEEN

(11) **EP 0 742 597 A1**
(43) Date de publication de la demande: **13.11.1996**
(21) Numéro de dépôt: 96400881.7
(22) Date de dépôt: 25.04.1996
(51) Int. Cl.: H01L 41/113, H01L 41/09, G01N 13/00

(54) **Transducteurs à bilames piézo-électriques**

(30) Priorité: 10.05.1995 FR 9505491
(71) Demandeur: ETAT FRANCAIS, Représenté par le Délégué Général, pour l'Armement, Paris 7ème (FR)
(72) Inventeur: Audoly, Christian, 83140 Six Fours (FR); Eyraud, Lucien, 69005 Lyon (FR); Roche, Denis, 69100 Villeurbanne (FR); Richard, Claude, 69006 Lyon (FR)

(57) **Abrégé**

L'invention concerne un transducteur électromécanique, destiné principalement à la mesure de contraintes de cisaillement statiques et dynamiques produites par des écoulements fluides hydrodynamiques ou aérodynamiques, laminaires ou turbulents, ou bien à la production de micro-déplacements, caractérisé en ce qu'il comporte au moins deux bilames piézoélectriques parallèles travaillant en double flexion.

## Description

La présente invention concerne un transducteur à bilames piézoélectriques de sensibilité élevée, conçu principalement pour mesurer les contraintes de cisaillement statiques et dynamiques produites par des écoulements fluides laminaires ou turbulents.

La détermination de force se fait très couramment avec précision, soit à l'aide de jauges piézorésistives disposées sur une pièce d'épreuve calibrée, soit avec des capteurs piézoélectriques permettant une mesure simultanée de plusieurs composantes. Les jauges piézorésistives sont des capteurs passifs traduisant en variation de résistance la déformation. Les capteurs piézoélectriques convertissent les variations de force en variations de charge électrique; la charge est alors mesurée par un simple amplificateur de charge.

Plus récemment, les travaux effectués sur les oscillateurs à ondes de surface ont permis la réalisation de capteurs de force ou de pression fiables et précis. Ils utilisent les propriétés non linéaires des cristaux et des céramiques piézoélectriques. La mesure de la contrainte ou de la force se résume, dans ce cas, à une mesure de variation de fréquence. Toutefois, la technique de mesure reste compliquée.

La détermination des forces de surface instables, sur une structure placée dans un écoulement hydraulique ou aérien, laminaire ou turbulent nécessite des capteurs de très haute sensibilité. L'ordre de grandeur des contraintes, environ la dizaine de Pa, n'autorise pas l'utilisation de capteurs piézoélectriques classiques, de sensibilité insuffisante. Jusqu'à présent, et dans le domaine d'écoulements aériens, des dispositifs tels que le tube de Preston, le tube de Stanton et les anémomètres à fil chaud ont permis d'estimer ces efforts par des méthodes de mesure indirecte. Les tubes de Preston et Stanton permettent la mesure d'une pression, les anémomètres, la mesure d'un échauffement. Ces méthodes sont basées sur des modèles théoriques pas toujours en accord avec la réalité.

Plus récemment, encore dans le cas d'applications aériennes, des capteurs de mesure directe tels que les senseurs à éléments flottants ont été réalisés. Ils permettent l'intégration des contraintes sur une surface. Ces contraintes provoquent le déplacement d'une armature mobile par rapport à une armature fixe, créant ainsi une variation de capacité.

Ces capteurs sont cependant inadaptés à un fonctionnement dans un milieu autre qu'aérien, tel qu'un milieu sous-marin.

Le but de l'invention est de proposer un transducteur permettant une mesure directe de force avec une sensibilité élevée capable de fonctionner en milieu sous-marin.

L'invention a pour objet un transducteur électromécanique, destiné principalement à la mesure de contraintes de cisaillement statiques et dynamiques produites par des écoulements fluides hydrodynamiques ou aérodynamiques, laminaires ou turbulents, ou bien à la production de micro-déplacements, caractérisé en ce qu'il comporte au moins deux bilames piézoélectriques parallèles travaillant en double flexion.

L'utilisation du transducteur comme capteur de force est d'une grande simplicité : seul un amplificateur de charge est nécessaire pour la mesure de la charge écoulée qui varie comme une fonction linéaire de l'effort appliqué.

L'utilisation de bilames présente, en outre, l'avantage de transformer une faible force en une forte déformation en flexion. Celle-ci se traduit par de fortes contraintes de traction ou de compression dans les lames constitutives du bilames et donc, par une charge générée importante.

L'élément sensible est adaptable. Il peut être intégré dans un capteur dont la configuration entraînera une sensibilité, soit à la pression hydrostatique, soit à la contrainte normale ou à la contrainte de cisaillement.

Dans un mode de réalisation préféré, le transducteur selon l'invention est tel que les bilames sont fixés par leurs extrêmités à deux armatures symétriques, dont l'une est fixe et l'autre flottante.

Dans un mode de réalisation préféré, le transducteur selon l'invention est tel que les armatures sont parallèles à la direction de l'effort de cisaillement à mesurer et qu'il est insensible à la pression appliquée sur la face de l'armature flottante perpendiculaire aux bilames.

Préférentiellement, les deux extrémités des bilames sont encastrées dans deux rainures des deux armatures, à l'aide d'un enrobage en résine polymère, pour limiter une éventuelle non linéarité liée à une éventuelle non continuité du contact mécanique avec les armatures.

L'utilisation de bilames encastrés à leurs deux extrémités et fonctionnant en double flexion permet d'obtenir simultanément une grande sensibilité liée à la structure bilame, une robustesse et une grande intégrité du montage.

Chaque lame piézoélectrique peut présenter une polarisation alternée.

Dans un autre mode de réalisation, le transducteur selon l'invention est tel que les bilames sont complètement enrobés dans une résine polymère.

La mise en parallèle de ces bilames enrobés constitue un matériau macrocomposite de grande sensibilité en cisaillement.

Le transducteur selon l'invention est intégrable dans un dispositif intelligent permettant la réduction du bruit d'écoulement autour d'une structure par contrôle actif.

Le fonctionnement du transducteur est réversible. Des micro déplacements pourront être obtenus à partir de l'application d'une tension électrique de commande.

Le transducteur peut être commandé par un champ électrique continu ou alternatif.

La description suivante se réfère aux dessins annexés qui représentent, sans aucun caractère limitatif, des modes de réalisation d'un transducteur selon l'invention.

La figure 1 est une vue de face d'un transducteur selon l'invention.

La figure 2 est une vue de face de la déformée du transducteur selon l'invention, soumis à un effort selon l'axe Ox.

La figure 3 est une vue éclatée d'un bilame piézoélectrique avec ses électrodes selon l'invention.

La figure 4 représente un premier mode de réalisation d'un transducteur selon l'invention.

La figure 5 représente un deuxième mode de réalisation d'un transducteur selon l'invention.

Le transducteur selon l'invention est un transducteur électromécanique.La force qu'il mesure est la résultante des contraintes de cisaillement appliquées par le flux sur une des faces du transducteur en contact avec l'écoulement.

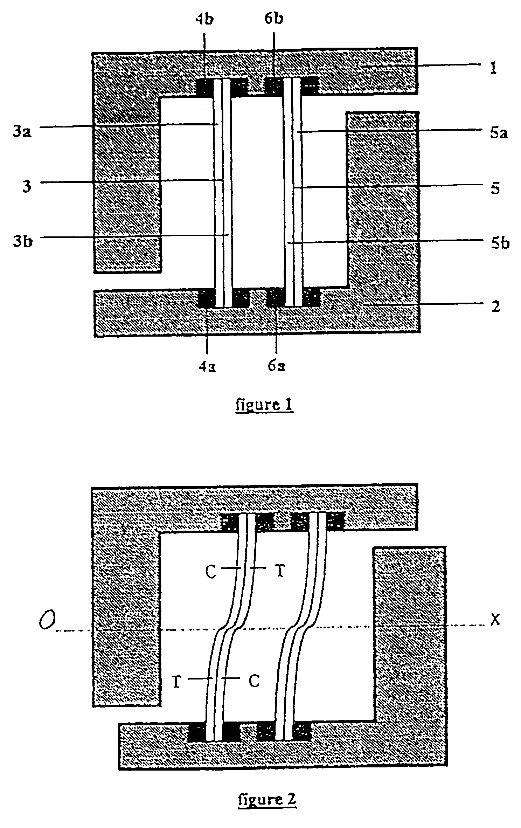

La grande sensibilité à la force du transducteur selon l'invention est obtenue en utilisant des éléments piézoélectriques montés en double ou multiple bilames. La figure 1 montre un transducteur à deux bilames parallèles.

Ces bilames identiques 3 et 5 sont constitués de deux lames piézoélectriques respectivement 3a/3b et 5a/5b, électrodées et polarisées, qui sont fixées à des armatures métalliques symétriques rigides 1 et 2.

Les bilames sont encastrés au niveau de leurs deux extrêmités au moyen d'enrobages 4a et 4b (respectivement 6a et 6b) réalisés avec une résine polymère dans deux rainures des armatures métalliques rigides 1 et 2. L'une de ces deux armatures est fixe et constitue une référence reliée au support du transducteur. La seconde armature est flottante et supporte l'effort à mesurer.

Les armatures sont parallèles à la direction de l'effort de cisaillement à mesurer et une pression appliquée sur la face de l'armature flottante perpendiculaire aux bilames n'a pas d'effet.

Les armatures ont une forme d'équerre de longueur 29 mm, de largeur 18 mm et de hauteur 13 mm.

Elles peuvent être réalisées en duralumin (AU4G).

Les deux bilames piézoélectriques 3 et 5 constitués chacun de deux lames piézoélectriques 3a et 3b (respectivement 5a et 5b)ont les dimensions suivantes : 0,4 mm x 20 mm x 12 mm.Ils sont en céramique PZT dopée au Niobium Nickel. Les électrodes sont déposées par sérigraphie; elles sont réalisées avec un vernis argenté de type AG7315 fabriqué par CERDEC.

Les lames 3a et 3b (respectivement 5a et 5b) sont assemblées par collage avec une résine époxide (Epotek E505).

Les encastrements 4a et 4b (respectivement 6a et 6b) sont réalisés avec une résine époxide (Ciba Geigy Araldite D + durcisseur HY956). Les sorties électriques sont réalisées par soudure à l'étain directe sur les groupements d'électrodes.

L'enrobage des extrémités des bilames avec un polymère dans les rainures des armatures permet de réaliser des encastrements facilement reproductibles et limitant une éventuelle non linéarité liée à une éventuelle non continuité du contact mécanique avec les armatures.

Le fait que les bilames soient encastrés à leurs deux extrémités permet de conférer une bonne intégrité au montage malgré la fragilité des bilames.

L'utilisation des structures bilames permet de transformer une faible force en une grande déformation en double flexion suivant le schéma de la figure 2.

La figure 2 montre schématiquement les déformations du transducteur lorsqu'il est soumis à un effort selon l'axe Ox. Elle met en évidence la double flexion ( traction T, compression C) des bilames. Le centre du bilame correspond à un point d'inflexion de la déformée, où la charge écoulée est minimale.

La double flexion entraîne de fortes contraintes de traction ou de compression dans les lames constitutives du bilame. Ces contraintes se traduisent par la génération d'une forte charge électrique par l'intermédiaire du couplage piézoélectrique latéral de chacune des lames.

Compte tenu de la déformation en double flexion des bilames, une métallisation et une polarisation appropriées sont nécessaires pour tirer le meilleur parti des charges écoulées.

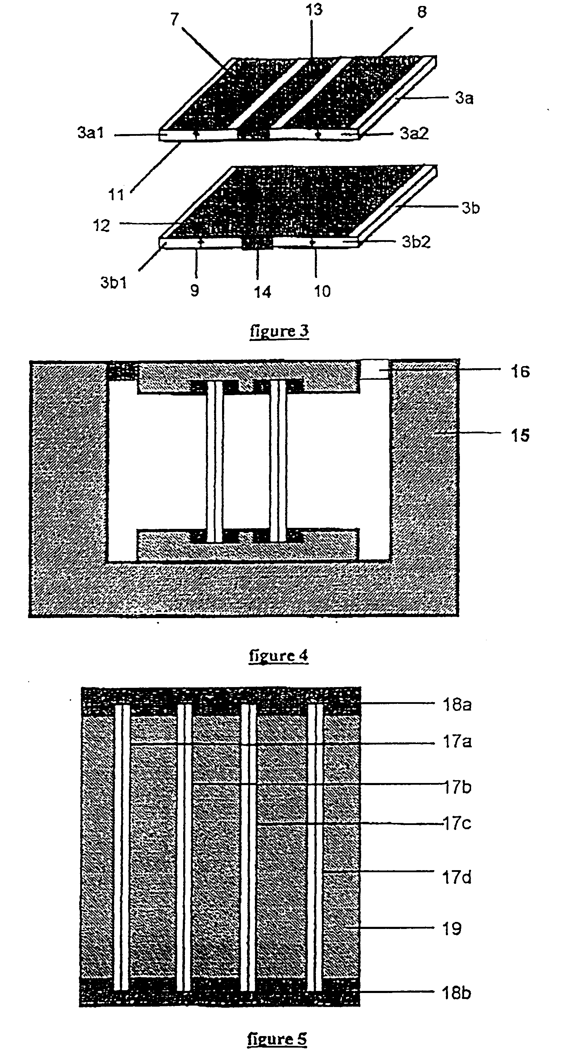

La figure 3 représente une vue éclatée des bilames utilisés. Chacune des lames 3a et 3b en face à face présente deux zones de part et d'autre d'une électrode centrale 13 pour la lame 3a et 14 pour la lame 3b, dont le sens de polarisation est opposé, suivant 3al et 3a2 pour la lame 3a et 3bl et 3b2 pour la lame 3b.

Des électrodes principales 11 pour la lame 3a et 12 pour la lame 3b sont reliées aux électrodes centrales respectives 13 et 14 par des reports sur les côtés des lames.La charge écoulée est minimale à l'endroit où se trouve le report des électrodes centrales.

Des électrodes secondaires 7 et 8 pour la lame 3a et 9 et 10 pour la lame 3b sont disposées de part et d'autre des électrodes centrales respectives 13 et 14, et sont en regard des électrodes principales respectives 11 et 12.

Les lames sont collées l'une sur l'autre de telle manière à assurer un contact mécanique et électrique entre les électrodes 11 et 12. Les électrodes 7,8,9 et 10 sont reliées directement entre elles. La charge électrique à mesurer apparaît entre le pôle électrique constitué par les électrodes principales et celui constitué par les électrodes secondaires.

La sensibilité du transducteur, obtenue par la mesure de la charge écoulée par rapport à la force appliquée selon l'axe Ox au transducteur, est quasi constante en fonction de la fréquence et égale à 130 nC/N jusqu'à 200 Hz environ.

La sensibilité du transducteur, obtenue par la mesure de la déformation du transducteur par rapport à la tension appliquée aux bilames, varie peu en fonction de la fréquence jusqu'à 300 Hz : elle est de 140 mm/V.

L'utilisation du transducteur comme capteur d'efforts tangentiels dans un écoulement aérodynamique nécessite son intégration dans une structure.

La figure 4 donne, à titre d'exemple, une vue en coupe d'un capteur où le transducteur à bilames piézoélectriques est solidaire d'un boîtier rigide 15. Dans le cas d'un écoulement hydrodynamique, l'étanchéité est assurée par un joint en résine polymère très souple 16.

Un autre mode de réalisation présentant une grande sensibilité au cisaillement se trouve en figure 5. Il s'agit d'un capteur, d'une grande compacité et parfaitement étanche, qui présente, de plus,l'avantage par rapport au mode de réalisation précédent d'une meilleure tenue en pression hydrostatique. Les bilames piézoélectriques 17a, 17b, 17c et 17d sont encastrés à leurs deux extrémités dans deux armatures 18a et 18b en résine polymère rigide. Une armature reste fixée au bâti, l'autre armature est en contact avec l'écoulement. Un enrobage total de la structure est réalisé avec une résine polymère 19 très souple. La détermination de la fraction volumique optimale de matériau actif résulte d'un compromis entre d'une part, la recherche d'une sensibilité idéale, obtenue sans résine d'enrobage, et, d'autre part, le fonctionnement d'un mode de réalisation avec enrobage. Une fraction volumique supérieure à 10% permet d'obtenir au moins 70% de la sensibilité idéale.

Ce transducteur est intégrable dans un dispositif intelligent permettant la réduction du bruit d'écoulement autour d'une structure par contrôle actif.

Il peut être commandé par un champ électrique continu ou alternatif.

Il peut également être utilisé dans tous les capteurs de force nécessitant une très grande sensibilité ou comme générateur de micro déplacements.

## Revendications

1. Transducteur électromécanique, destiné principalement à la mesure de contraintes de cisaillement statiques et dynamiques produites par des écoulements fluides hydrodynamiques ou aérodynamiques, laminaires ou turbulents, ou bien à la production de micro-déplacements, caractérisé en ce qu'il comporte au moins deux bilames piézoélectriques parallèles travaillant en double flexion.

2. Transducteur selon la revendication 1, caractérisé en ce que les bilames sont fixés par leurs extrêmités à deux armatures symétriques, dont l'une est fixe et l'autre flottante.

3. Transducteur selon l'une des revendications 1 à 2, caractérisé en ce que les armatures sont parallèles à la direction de l'effort de cisaillement à mesurer et qu'il est insensible à la pression appliquée sur la face de l'armature flottante perpendiculaire aux bilames.

4. Transducteur selon l'une des revendications 1 à 3 caractérisé en ce que les deux extrémités des bilames sont encastrées dans deux rainures des deux armatures, à l'aide d'un enrobage en résine polymère.

5. Transducteur selon l'une quelconque des revendications 1 à 4, caractérisé en ce que chaque lame piézoélectrique présente une polarisation alternée.

6. Transducteur selon l'une quelconque des revendications 1 à 5, caractérisé en ce que les bilames sont complètement enrobés dans une résine polymère.

7. Transducteur selon l'une quelconque des revendications 1 à 6, caractérisé en ce qu'il est intégrable dans un dispositif intelligent permettant la réduction du bruit d'écoulement autour d'une structure par contrôle actif.

8. Transducteur selon l'une quelconque des revendications 1 à 7, caractérisé en ce qu'il est réversible et est commandable par un champ électrique continu ou alternatif pour générer des micro-déplacements.
